# FASCICULE DE BREVET EUROPEEN

(11) **EP 1 868 233 B1**
(45) Date de publication et mention de la délivrance du brevet: **11.03.2009**
(21) Numéro de dépôt: 07109927.9
(22) Date de dépôt: 08.06.2007
(51) Int. Cl.: H01L 21/321, H01L 21/84

(54) **Procédé de réalisation de zones à base de Si1-yGey de différentes teneurs en Ge sur un même substrat par condensation de germanium**
Verfahren zur Herstellung von auf Si1-yGey basierenden Zonen mit unterschiedlichen Ge-Gehalten auf ein und demselben Substrat mittels Kondensation von Germanium
Method of manufacturing zones based on Si1-yGey with different Ge contents in the same substrate by germanium condensation

(30) Priorité: 12.06.2006 FR 0652094; 06.12.2006 FR 0655336
(43) Date de publication de la demande: 19.12.2007
(73) Titulaire: COMMISSARIAT A L'ENERGIE ATOMIQUE, 75015 Paris (FR); STMICROELECTRONICS SA, 92120 Montrouge (FR)
(72) Inventeur: Damlencourt, Jean-François, 38120, SAINT EGREVE (FR); Morand, Yves, 38000, GRENOBLE (FR); Clavelier, Laurent, 38700, VOIRON (FR)
(74) Mandataire: Poulin, Gérard

(56) Documents cités:
- US-A1- 2004 178 406
- US-A1- 2005 098 234
- US-A1- 2005 269 595
- BERA L. K. ET AL.: "A dual-strained CMOS structure through simultaneous formation of relaxed and compressive strained-SiGe-on-insulator" IEEE ELECTRON DEVICE LETTERS, vol. 27, no. 5, 5 mai 2006 (2006-05-05), pages 350-353, XP002424653
- TEZUKA T ET AL: "HIGH-MOBILITY STRAINED SIGE-ON-INSULATOR PMOSFETS WITH GE-RICH SURFACE CHANNELS FABRICATED BY LOCAL CONDENSATION TECHNIQUE" IEEE ELECTRON DEVICE LETTERS, IEEE SERVICE CENTER, NEW YORK, NY, US, vol. 26, no. 4, avril 2005 (2005-04), pages 243-245, XP001230451 ISSN: 0741-3106

## Description

### DOMAINE TECHNIQUE

L'invention concerne un procédé de réalisation d'un dispositif microélectronique amélioré dans lequel des blocs semi-conducteurs à base de Si_{1-y}Ge_{y} de compositions différentes sont formés sur un même substrat.

L'invention peut favoriser l'intégration, sur un même support semi-conducteur, ou une même puce, ou une même plaquette semi-conductrice, à la fois d'une première pluralité de transistors comprenant une couche active à base d'un matériau optimisé pour la conduction des électrons et d'une deuxième pluralité de transistors comprenant une couche active à base d'un matériau optimisé pour la conduction des trous, les performances des transistors de la première pluralité de transistors et de la deuxième pluralité de transistors étant équilibrées.

### ART ANTÉRIEUR

Dans le but d'améliorer les performances des transistors, notamment en terme de rapidité, il est connu de former pour ces derniers des canaux dits « contraints » pour lesquels la mobilité des électrons ou des trous est améliorée. Un canal contraint est généralement formé d'au moins une première couche semi-conductrice à base d'un premier matériau semi-conducteur sur laquelle est appliquée une contrainte mécanique en tension ou en compression par l'intermédiaire d'une autre couche sous-jacente à, ou située sur, ladite première couche semi-conductrice et par exemple à base d'un matériau semi-conducteur cristallin à paramètre de maille différent dudit premier matériau semi-conducteur. Un matériau semi-conducteur approprié pour favoriser une bonne mobilité des trous l'est souvent moins en ce qui concerne la mobilité des électrons. Ainsi, une contrainte en tension ou en compression effectuée sur un matériau semi-conducteur donné permet d'augmenter de manière plus importante dans ce matériau la mobilité d'un type de porteur plutôt que de l'autre. Pour des dispositifs microélectroniques tels que des circuits en technologie CMOS, comportant à la fois un ou plusieurs transistors assurant une conduction principale par trous et un ou plusieurs autres transistors assurant une conduction principale par électrons, il s'avère difficile de pouvoir augmenter, par le biais de canaux contraints, à la fois la mobilité des porteurs de charge pour les transistors de type N et pour les transistors de type P. Dans ce type de circuit, il est par ailleurs généralement préférable que les performances des transistors de type N et celles des transistors de type P soient équilibrées en terme de courant à l'état passant ou en terme de mobilité, ce qui entraîne une difficulté supplémentaire. Une solution consister à réaliser un dispositif microélectronique doté de zones semi-conductrices à base de matériaux semi-conducteurs différents sur un même substrat, et en particulier de zones semi-conductrices à base d'un matériau semi-conducteur favorisant une conduction par électrons et de zones semi-conductrices à base d'un autre matériau semi-conducteur favorisant une conduction par trous.

Le document US 6 600 170 présente une réalisation sur un substrat semi-conducteur massif, d'une zone semi-conductrice de canal à base Si contraint pour un transistor NMOS et d'une zone semi-conductrice de canal à base de SiGe ou Ge contraint pour un transistor PMOS. Une telle architecture permet d'obtenir des performances équilibrées entre les transistors NMOS et PMOS. En terme de consommation notamment, les performances de transistors d'une telle structure ne sont pas optimales. Des effets de canal court ainsi que de « latch up » peuvent notamment apparaître dans les transistors.

Le document FR 04 50889 présente quant à lui un procédé microélectronique de réalisation de zones semi-conductrices actives de natures différentes directement sur isolant. Ce procédé comprend des étapes consistant à : former sur un premier substrat, d'au moins une première zone semi-conductrice en un premier matériau semi-conducteur cristallin, et d'au moins une deuxième zone semi-conductrice en un second matériau semi-conducteur cristallin différent du premier semi-conducteur cristallin, puis recouvrir lesdites première et deuxième zones d'une épaisseur isolante, puis assembler un deuxième substrat sur ladite épaisseur isolante, puis éliminer le premier substrat. Un tel procédé comprend un nombre important d'étapes intermédiaires.

Le document US 2004/178406 A1 décrit un procédé de réalisation d'un dispositif microélectronique comportant une pluralité de zones semi-conductrices à base de Si_{1-y} Ge_{y} (avec 0<y<1) ayant des teneurs respectives en germanium différentes, dans lequel une première couche de SiGe est formée sur un support, la teneur en germanium de cette couche étant telle qu'elle se trouve contrainte en tension; après élimination entière de la couche de SiGe dans des zones définies, une croissance sélective d'une nouvelle couche de SiGe est réalisée dans ces zones définies, la nouvelle couche comprenant une teneur en germanium telle qu'elle se trouve en compression.

Il se pose le problème de trouver un nouveau procédé microélectronique de réalisation sur un même substrat d'un ensemble de zones semi-conductrices de compositions différentes, comportant par exemple plusieurs zones semi-conductrices à base d'un matériau favorisant la conduction par électrons et plusieurs autres zones semi-conductrices à base d'un matériau favorisant la conduction par trous.

### EXPOSÉ DE L'INVENTION

L'invention concerne un procédé de réalisation d'un dispositif microélectronique comportant une pluralité de zones semi-conductrices à base de Si_{1-y}Gey (avec 0 < y ≤ 1) ayant des teneurs respectives en Germanium différentes, comprenant les étapes de :
a) formation sur une pluralité de zones semi-conductrices à base de Si et d'épaisseurs différentes reposant sur un support, d'une couche semi-conductrice à base de Si₁₋ₓGeₓ (avec 0 < x < 1 et x < y),
b) oxydation de la couche semi-conductrice à base de Si₁₋ₓGeₓ.

Les zones semi-conductrices à base de Si et d'épaisseurs différentes peuvent être des zones d'une couche à base de Si et formant biseau.

La forme de biseau de la couche à base de Si peut avoir été réalisée préalablement à l'étape a) par :
- formation d'un masquage en forme de biseau sur la couche à base de Si,
- oxydation de la couche de Si à travers ledit masquage en forme de biseau,
- retrait dudit masquage en forme de biseau.

Ledit masquage en forme de biseau peut être à base d'un matériau isolant, par exemple à base de SiO₂.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels .

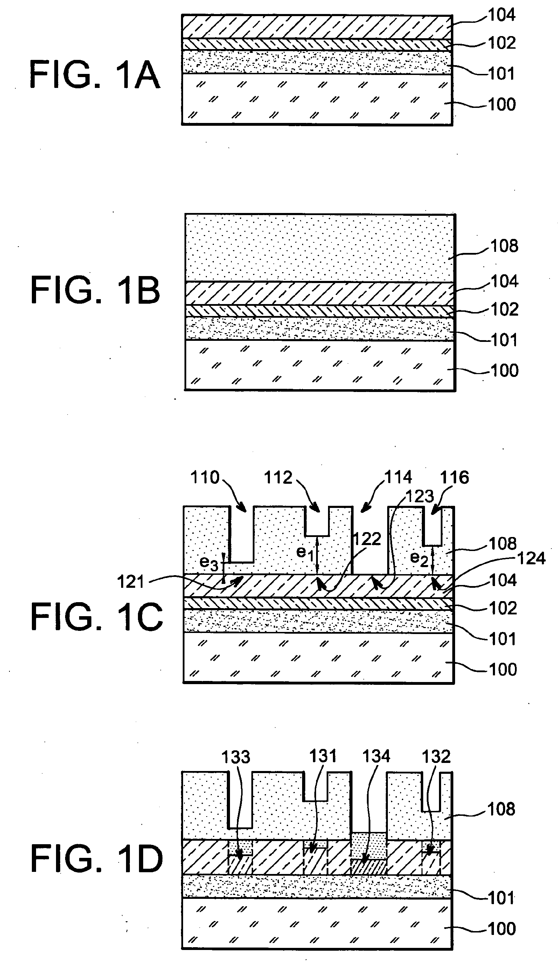

- les figures 1A-1D, illustrent un exemple de procédé microélectronique de réalisation sur un substrat, de plusieurs zones semi-conductrices à base de Si_{1-y}Ge_{y} (avec 0 < y ≤ 1) de compositions en germanium différentes, à l'aide d'au moins une étape de condensation de Germanium réalisée sur une couche à base de Si₁₋ₓGeₓ (avec 0 < x < y < 1) protégée par un masquage d'épaisseur variable,

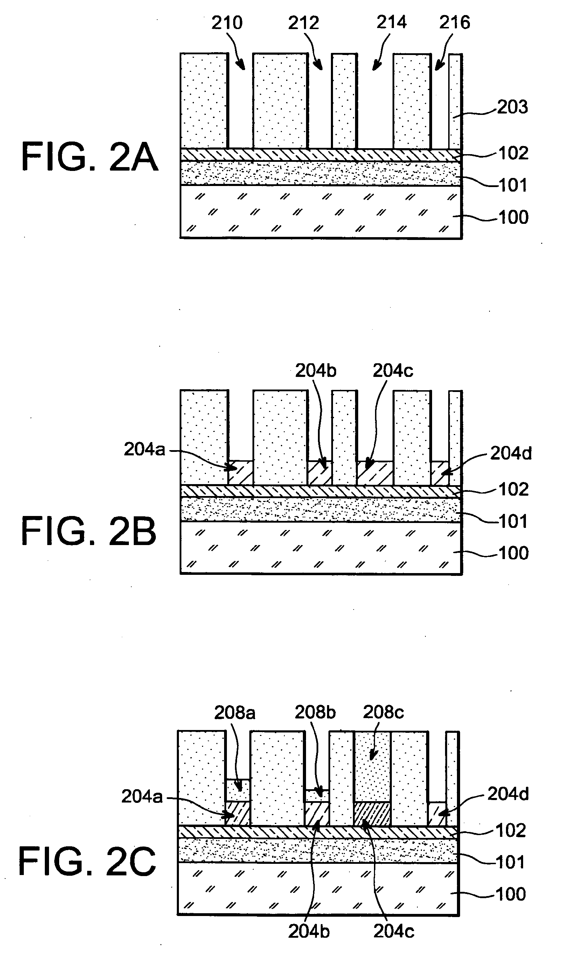

- les figures 2A-2D, illustrent un autre exemple de procédé microélectronique de réalisation sur un substrat, de plusieurs zones semi-conductrices à base de Si_{1-y}Ge_{y} (avec 0 < y ≤ 1) de compositions en germanium différentes, à l'aide d'au moins une étape de condensation de Germanium réalisée sur des zones semi-conductrices à base de Si₁₋ₓGeₓ (avec 0 < x < y < 1) de compositions en germanium identiques et protégés par un masquage d'épaisseur variable,

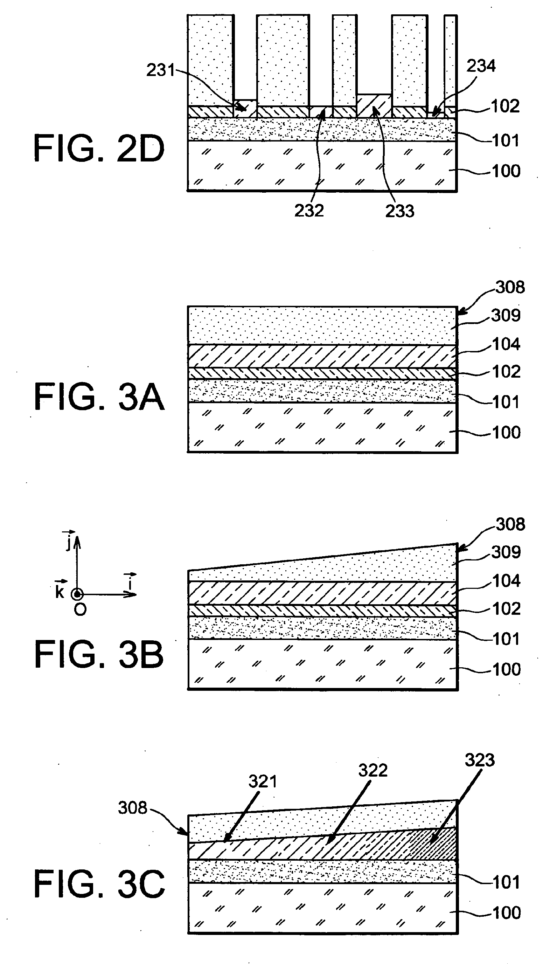

- les figures 3A-3C, illustrent un autre exemple de procédé microélectronique de réalisation sur un substrat, de plusieurs zones semi-conductrices à base de Si_{1-y}Ge_{y} (avec 0 < y ≤ 1) de compositions en germanium différentes, à l'aide d'au moins une étape de condensation de Germanium réalisée sur une couche à base de Si₁₋ₓGeₓ (avec 0 < x < y < 1) protégée par un masquage en forme de biseau,

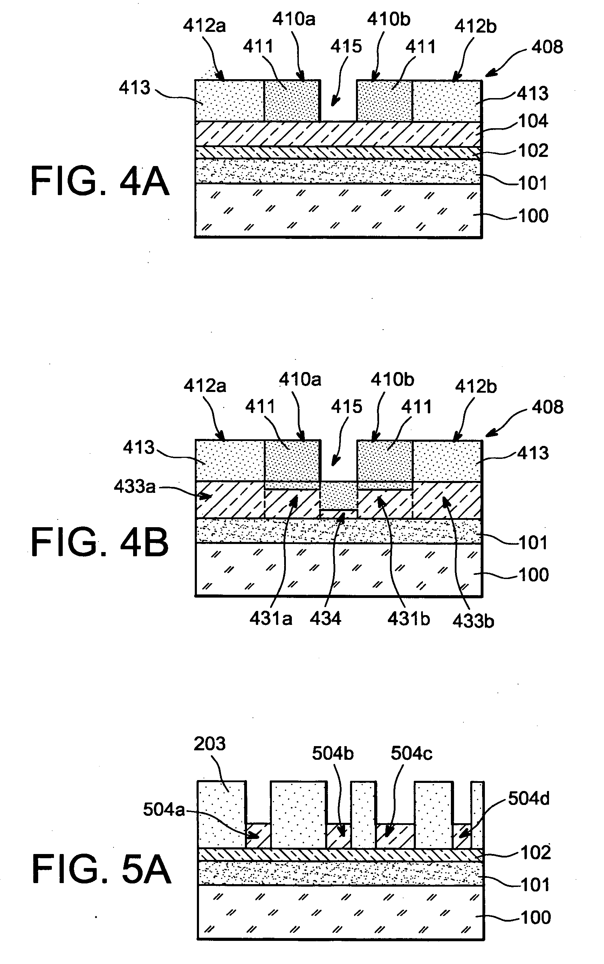

- les figures 4A-4B, illustrent un autre exemple de procédé microélectronique de réalisation sur un substrat, de plusieurs zones semi-conductrices à base de Si_{1-y}Ge_{y} (avec 0 < y ≤ 1) de compositions en germanium différentes, à l'aide d'au moins une étape de condensation de Germanium réalisée sur une couche à base de Si₁₋ₓGeₓ (avec 0 < x < y < 1) protégée par un masquage formé de zones de natures différentes,

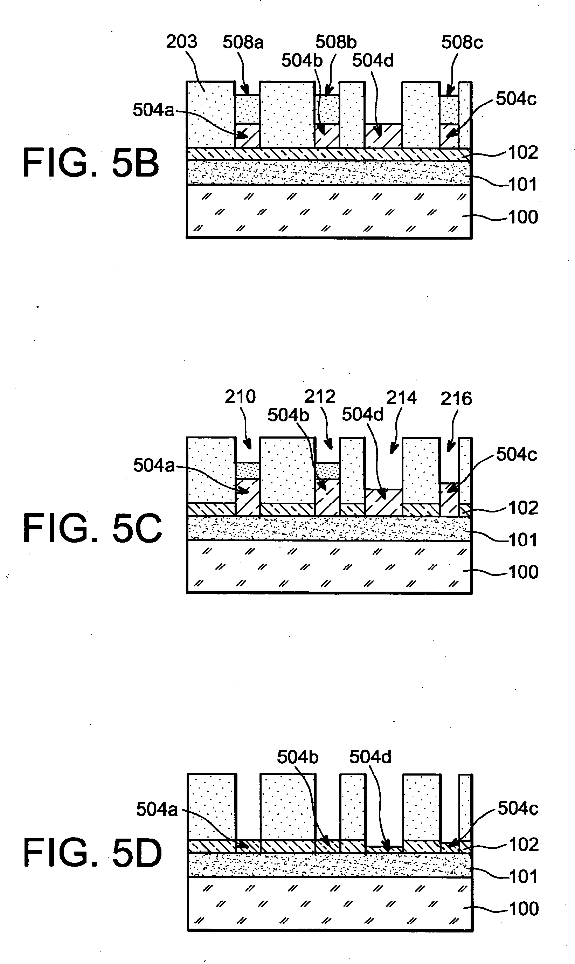

- les figures 5A-5D, illustrent un autre exemple de procédé microélectronique de réalisation sur un substrat, au cours duquel plusieurs étapes d'oxydation de zones semi-conductrices à base de Si₁-ₓGeₓ sont réalisées, à l'aide à chaque fois d'un masquage différent,

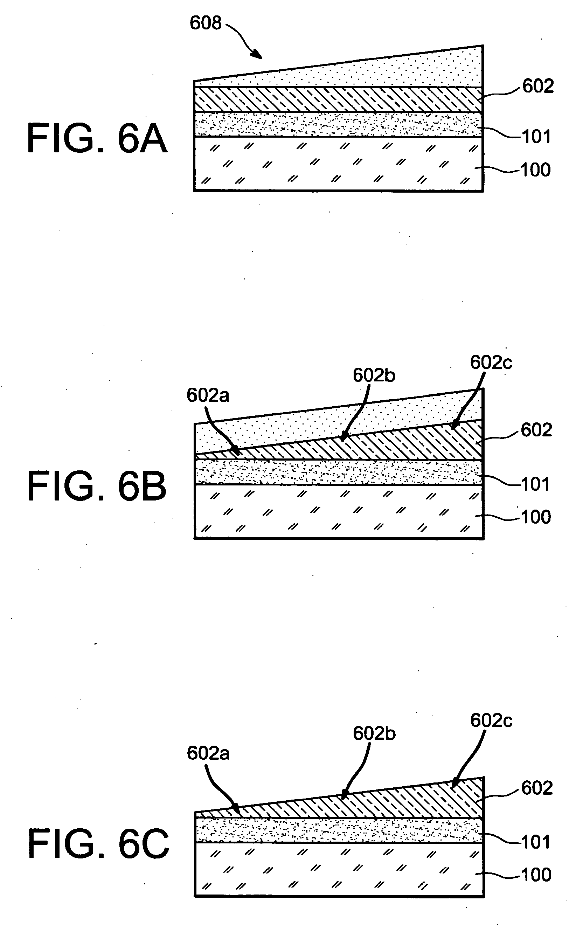

- les figures 6A-6E, illustrent un exemple de procédé microélectronique selon l'invention de réalisation sur un substrat, de plusieurs zones semi-conductrices à base de Si_{1-y}Ge_{y} (avec 0 < y ≤ 1) de compositions en germanium différentes, à l'aide d'au moins une étape de condensation de Germanium réalisée sur une couche à base de Si₁₋ₓGeₓ (avec 0 < x < y < 1) en forme de biseau,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un exemple de procédé de réalisation d'un dispositif microélectronique doté de plusieurs zones semi-conductrices à base de Si_{1-y}Ge_{y} (avec 0 <y ≤ 1) ayant des compositions respectives en Germanium différentes formées sur un même substrat, va à présent être donné en liaison avec les figures 1A à 1D. Le matériau de départ du procédé peut être un substrat de type semi-conducteur sur isolant, par exemple de type SOI (SOI pour « silicon on insulator » ou silicium sur isolant) comprenant une couche de support 100 par exemple à base de Si, recouverte d'une couche de matériau diélectrique 101 par exemple une couche d'oxyde enterré (« burried oxyde » selon la terminologie anglo-saxonne) elle-même recouverte d'une fine couche semi-conductrice 102 par exemple à base de Si, et d' épaisseur comprise par exemple entre 5 et 100 nanomètres ou par exemple de l'ordre de 20 nanomètres. Sur la fine couche semi-conductrice 102 une autre couche semi-conductrice 104 à base de Si₁₋ₓGeₓ, avec 0<x<y≤1, par exemple avec x de l'ordre de 0,1, d'épaisseur comprise par exemple entre 50 et 300 ou par exemple entre 50 et 100 nanomètres ou par exemple entre 40 et 75 nanomètres est formée, par exemple par épitaxie (figure 1A).

Un masquage à oxydation est ensuite réalisé sur la couche semi-conductrice 104 à base de Si₁₋ₓGeₓ. Le masquage peut être formé d'au moins une couche 108 qui peut être à base d'un matériau diélectrique par exemple tel que du SiO₂ ou du Si₃N₄, ou d' un empilement de sous-couches de matériau(x) diélectrique(s), par exemple d'une sous-couche à base d'un premier matériau diélectrique tel que du Si₃N₄, recouverte d'une autre sous-couche à base d'un deuxième matériau diélectrique, par exemple tel que du SiO₂, ou, selon un autre exemple, d'une sous-couche à base de SiO₂, recouverte d'une sous-couche à base de Si₃N₄. La couche 108 de masquage peut être réalisée par dépôt et peut avoir une épaisseur par exemple de l'ordre de 100 nanomètres, ou comprise par exemple entre 20 et 500 nanomètres (figure 1B) .

Ensuite, on réalise un ensemble de trous 110, 112, 114, 116, dans la couche 108 de matériau diélectrique ou dans l'empilement de couches de matériaux diélectriques. Les trous 110, 112, 114, 116, formés ont respectivement une profondeur donnée et réalisent respectivement un motif donné. Plusieurs des trous 110, 112, 114, 116, formés dans la couche 108 de masquage peuvent avoir des profondeurs différentes et éventuellement réaliser des motifs différents. Les trous 110, 112, 114, 116, peuvent être réalisés par exemple par un procédé comprenant au moins une étape de photolithographie ou de lithographie par faisceau d'électrons, ou à l'aide d'un procédé de type dit « nano-imprint » dans lequel les trous 110, 112, 114, 116, sont réalisés par emboutissage, à l'aide d'un moule doté de motifs saillants, et que l'on applique par pressage sur la couche 108 de matériau diélectrique ou sur l'empilement de couches de matériaux diélectriques. Certains trous 110, 112, 116, peuvent avoir un fond situé au niveau de la couche 108 de masquage et dévoiler une portion de cette dernière. La couche 108 de masquage peut également comporter un ou plusieurs autres trous 114 dévoilant la couche semi-conductrice 104. La couche 108 de masquage dotée des trous 110, 112, 114, 116, de profondeurs différentes forme une pluralité d'éléments masquant ou de blocs de masquage d'épaisseurs différentes reposant sur la couche semi-conductrice 104 (figure 1C).

Ensuite, on effectue une étape de condensation localisée du Ge de la couche 104 semi-conductrice à base de Si₁₋ₓGeₓ, par exemple à l'aide d'un procédé d'oxydation tel que décrit dans le document : « A novel fabrication technique of ultrathin and relaxed SiGe buffer layers with high Ge fraction for sub-100 nm strained silicon on insulator MOSFETs, Tezuka et al., Japaneese Journal of Applied Physics, vol. 40, p 2866-2874, 2001 » ou dans le document « Selectively formed high mobility SiGe on Insulator pMOSFETs with Ge-rich strained surface channels using local condensation technique, Tezuka et al., Symposium on VLSI Technology, 2004 ». Pour effectuer cette condensation de Ge, au moins une étape d'oxydation thermique de la couche semi-conductrice 104 à base de Si₁₋ₓGeₓ est réalisée à haute température, et à travers le masquage formé de blocs de masquage d'épaisseurs différentes. La température d'oxydation est de préférence inférieure à la température de fusion du matériau Si₁₋ₓGeₓ de la couche semi-conductrice 104. Une oxydation en une ou plusieurs étapes et à des températures décroissantes peut être réalisée.

Durant l'étape d'oxydation du silicium de la fine couche semi-conductrice 102, et de la couche 104 à base de Si₁₋ₓGeₓ, ont tendance à se consommer, de manière à former du SiO₂. Le germanium étant très peu ou pas soluble dans le SiO₂, il est rejeté au niveau de l'interface entre la fine couche semi-conductrice 102 et de la couche 101 d'oxyde enterré.

Les éléments masquant ou blocs de masquage de la couche 108, induisent un retard à l'oxydation des couches semi-conductrices 102 et 104, plus ou moins important en fonction de leurs épaisseurs respectives. L'oxydation d'une première région 121 de la couche semi-conductrice 104, située sous un premier bloc de masquage d'une première épaisseur e₁ donnée, est destinée à être plus lente que celle d'une deuxième région 122 de la couche semi-conductrice 104, située sous un deuxième bloc de la couche 108 d'une deuxième épaisseur e₂ telle que e₂ ≤ e₁, elle même destinée à être plus lente que celle d'une troisième région 123 de la couche semi-conductrice 104, située sous un troisième bloc de la couche 108 d'une troisième épaisseur e₃ telle que e₃ ≤ e₂, elle même destinée à être plus lente que celle d'une quatrième région 124 des couches 104, 108, située dans le prolongement d'un trou 114 dévoilant la couche semi-conductrice 104.

Une fois l'étape d'oxydation terminée, on obtient plusieurs zones 131, 132, 133, 134 à base de Si_{1-y}Ge_{y} (avec y>x) de compositions respectives en Germanium ou de teneurs respectives en Germanium différentes. La durée de l'étape d'oxydation peut avoir été adaptée en fonction de la concentration en Germanium que l'on souhaite obtenir dans les différentes zones semi-conductrices à base de Si_{1-y}Ge_{y}. La première zone 131 à base de Si_{1-y}Ge_{y}, a une première composition en Germanium telle que y=y₁, y₁ étant par exemple de l'ordre de 0,1, tandis que la deuxième zone à base de Si_{1-y}Ge_{y}, a une deuxième composition en Germanium différente de la première composition et telle que y=y2 avec y2 > y₁, y₂ étant par exemple de l'ordre de 0,4, la troisième zone à base de Si_{1-y}Ge_{y} a une troisième composition en Germanium, différente de la première et de la deuxième compositions, et telle que y=y₃ avec y₃ > y₂, y₂ étant par exemple de l' ordre de 0, 7 la quatrième zone à base de Si_{1-y}Ge_{y} a une quatrième composition en Germanium, différente de la première, de la deuxième, et de la troisième composition telle que y=y₄ avec y₄ > y₃, y₄ étant par exemple de l'ordre de 1. Les zones 131, 132, 133, 134 à base de Si_{1-y}Ge_{y} ayant des teneurs en germanium différentes peuvent être par exemple destinées à servir respectivement de zone de canal de transistor. Une fois l'étape d'oxydation terminée, les zones 131, 132, 133, 134 à base de Si₁-_{y}Ge_{y} peuvent être surmontées respectivement d'une couche 135 à base de SiO₂ formée lors de l'oxydation. Cette couche 135 ainsi que la couche de masquage 108 peuvent être ensuite retirées (figure 1D).

Selon une possibilité de mise en oeuvre (non représentée) du procédé qui vient d'être décrit, avant dépôt de la couche 108 de masquage, la couche semi-conductrice 104 à base de Si₁₋ₓGeₓ peut être recouverte par une fine couche semi-conductrice à base de silicium, par exemple d'épaisseur comprise entre 1 et 5 nanomètres. Cette fine couche semi-conductrice peut permettre d'éviter une consommation du Germanium lors de l'étape d'oxydation de la couche semi-conductrice 104.

Dans l'exemple de procédé précédemment décrit, le matériau utilisé pour former le masquage à l'oxydation est un matériau apte à retarder l'oxydation de la couche semi-conductrice 104, et n'est pas nécessairement limité à un matériau diélectrique.

Selon une variante de l'exemple de procédé précédemment décrit, au lieu de former une couche semi-conductrice 104 à base de Si₁₋ₓGeₓ, on réalise sur la fine couche semi-conductrice 102 plusieurs zones semi-conductrices distinctes ou disjointes, à base de Si₁-ₓGeₓ et ayant des compositions en Germanium identiques. On dépose tout d'abord sur la fine couche semi-conductrice 102 une couche de masquage 203 par exemple à base d'un matériau diélectrique tel du Si₃N₄. La couche de masquage 203 peut avoir une épaisseur par exemple de l'ordre de 100 nanomètres, ou comprise par exemple entre 50 et 400 nanomètres.

Dans la couche 203 de masquage, on réalise ensuite un ensemble de trous 210, 212, 214, 216, dévoilant la fine couche semi-conductrice 102 (figure 2A). Selon un exemple de mise en oeuvre, les trous 210, 212, 214, 216, peuvent avoir respectivement une forme de grille de transistor ou de canal de transistor.

Ensuite, on forme un ensemble de zones 204a, 204b, 204c, 204d, semi-conductrices à base de Si₁₋ₓGeₓ (avec 0≤x≤1, par exemple avec x de l'ordre de 0,1) par exemple par épitaxie au fond des trous 210, 212, 214, 216, sur la fine couche semi-conductrice 102 (figure 2B).

Puis, dans plusieurs trous 210, 212, 214, dudit ensemble de trous, sur plusieurs zones 204a, 204b, 204c, dudit ensemble de zones semi-conductrices à base de SiGe, on forme un bloc de masquage. Un ensemble de plusieurs blocs 208a, 208b, 208c, de masquage comblant respectivement un trou et recouvrant une zone semi-conductrice à base de Si₁₋ₓGeₓ est ainsi formé. Les blocs 208a, 208b, 208c, de masquage peuvent être par exemple à base d'un matériau diélectrique tel que par exemple du SiO₂. Plusieurs blocs 208a, 208b, 208c, de masquage peuvent avoir des épaisseurs différentes. Les blocs 208a, 208b, 208c, de masquage peuvent avoir une épaisseur comprise par exemple entre 10 nm et 300 nm (figure 2C).

Une étape d'oxydation des zones 204a, 204b, 204c, 204d, à base de SiGe est réalisée à haute température, à travers le masquage formé par la couche 203 ajourée et les blocs de masquage 208a, 208b, 208c, situés dans les trous. L'étape d'oxydation consomme le silicium de la fine couche semi-conductrice 102, et des zones 204a, 204b, 204c, 204d, à base de Si_{1-y}Ge_{y}. Les blocs de masquage 208a, 208b, 208c, en fonction de leurs épaisseurs respectives, sont susceptibles d'induire un retard à l'oxydation ou d'empêcher l'oxydation de la couche semi-conductrice 102 et des zones 204a, 204b, 204c, 204d.

Une fois l'étape d'oxydation terminée, on obtient plusieurs zones 231, 232, 233, 234, à base de Si_{1-y}Ge_{y} ayant des compositions respectives en Germanium différentes par exemple telles que 0,1 ≤ y ≤1. Les zones 231, 232, 233, 234, à base de Si_{1-y}Ge_{y} peuvent être surmontées respectivement d'une couche à base de SiO₂ formée lors de l'oxydation.

Les blocs de masquage 208a, 208b, 208c, et la couche à base de SiO₂ formée lors de l'oxydation peuvent être ensuite retirés. Dans un cas où l'on souhaite conserver la couche 203, le retrait peut être effectué par gravure sélective vis-à-vis de la couche 203. Si par exemple les blocs de masquage 208a, 208b, 208c sont à base de SiO₂ et que la couche 203 est à base de Si₃N₄, la gravure sélective peut être réalisée en voie humide à l'aide par exemple de HF, ou par exemple par gravure plasma avec du C₄F₈ et un mélange d'argon et d'oxygène (figure 2D).

Selon une possibilité, les zones 231, 232, 233, 234, à base de Si_{1-y}Ge_{y} et de compositions respectives en Germanium différentes, peuvent être destinées respectivement à former un canal de transistor. Des transistors dotés de zones de canal à base de Si_{1-y}Ge_{y} (avec y>x) et de compositions respectives en Germanium différentes peuvent être ainsi réalisés. Pour compléter la formation de transistors, on peut réaliser une grille sur chaque zone 231, 232, 233, 234, à base de Si_{1-y}Ge_{y}. Pour cela, suite au retrait des blocs de masquage 208a, 208b, 208c, et de la couche 235, un matériau diélectrique de grille, par exemple du HfO₂ peut être tout d'abord déposé dans les trous 210, 212, 214, 216, puis au moins un matériau grille, comprenant par exemple au moins un matériau métallique tel que du TiN ou/et au moins un matériau semi-conducteur tel que du polysilicium, qui peut être fortement dopé, par exemple avec du Bore avec un dopage de l'ordre de 10²⁰ atomes/cm³. Le remplissage des trous 210, 212, 214, 216, par le matériau de grille peut être suivi d'une étape de CMP (CMP pour « chemical mechanical polishing » ou polissage mécano chimique).

Dans un cas par exemple ou les zones semi-conductrices 231, 232, 233, 234, à base de Si_{1-y}Ge_{y} sont formées avec une composition en Germanium importante, par exemple telle que y est proche de 1, le dépôt du matériau diélectrique de grille peut être précédé par une étape de formation d'une couche d'interface à base de SiO₂ et d'épaisseur par exemple comprise entre 0,3 et 3 nanomètres. La couche d'interface peut être réalisée par exemple par croissance d'une fine couche de silicium sur les zones semi-conductrices 231, 232, 233, 234, à base de Si_{1-y}Ge_{y} puis oxydation de cette fine couche de silicium.

Selon une autre variante de l'exemple de procédé précédemment décrit en liaison avec les figures 1A-1D, on dépose sur la couche semi-conductrice 104 à base de Si₁₋ₓGeₓ, une couche 308 de masquage à base d'un matériau diélectrique 309, par exemple tel que du SiO₂, et d'épaisseur par exemple comprise entre 20 nanomètres et 1000 nanomètres (figure 3A). Ensuite, on effectue un retrait d'une partie de la couche 308 de masquage, de manière à lui donner une forme de biseau. Suite à ce retrait, la face supérieure de la couche 308 de masquage réalise un angle non nul avec le plan principal du support 100 ou forme une pente inclinée par rapport au plan principal du support 100 (le plan principal du support 100 étant défini comme un plan passant par le support 100 et parallèle au plan [O; *i̅* ; *k̅* ] d'un repère orthogonal [O; *i̅* ; *j̅* ; *k̅*]). Dans un cas, par exemple, où le matériau diélectrique 309 est du SiO₂, le retrait peut être effectué par exemple par trempage du substrat recouvert par la couche 308 de masquage, dans une solution à base de HF + H₂O, puis par retrait progressif de la solution (figure 3B).

Ensuite, on réalise une oxydation de la couche semi-conductrice 104, à haute température semblable à celle décrite dans l'un ou l'autre des exemples de procédé précédemment décrits. La couche 308 en forme de biseau joue le rôle d'un masquage pour cette oxydation. A la suite de cette oxydation, entre la couche 308 de masquage et la couche 104, des zones semi-conductrices 331, 332, 333, à base de Si_{1-y}Ge_{y} (avec y>x) et à différentes teneurs en Ge ou à différentes compositions en germanium, sont formées. Un gradient de concentration en Ge peut être obtenu dans l'épaisseur semi-conductrice située entre la couche isolante 101 et la couche de masquage, dans une direction parallèle au plan principal du support 100. Ce gradient est dépendant de l'angle que réalisait la face supérieure de la couche de masquage 308 avec le plan principal du support 100.

Selon un autre exemple de procédé, on réalise sur la couche semi-conductrice 104 à base de Si₁₋ₓGeₓ, un masquage 408, comprenant une pluralité de blocs 410a, 410b, 412a, 412b, dont au moins deux blocs 410a, 412a, de compositions différentes ou formés à base de matériaux différents. Le masquage 408 peut être formé par exemple de plusieurs blocs 410a, 410b, à base d'un premier matériau 411 qui peut être diélectrique tel que par exemple du SiO₂ et de plusieurs autres blocs 412a, 412b, à base d'un deuxième matériau 413 qui peut être diélectrique tel que par exemple du Si₃N₄-Dans cet exemple, les blocs 410a, 410b, 412a, 412b, de masquage peuvent avoir des épaisseur identiques. Les blocs 410a, 410b, à base du premier matériau diélectrique 411 et les blocs 412a, 412b, à base du deuxième matériau 413 diélectrique peuvent être réalisés à l'aide d'un procédé comprenant par exemple plusieurs étapes de dépôt et de photolithographie (figure 4A).

Ensuite, une étape d'oxydation de la couche semi-conductrice 104, telle que décrite précédemment, est réalisée à travers les blocs de masquage 410a, 410b, 412a, 412b. De par leurs compositions différentes, les blocs de masquage 410a, 410b, à base du premier matériau diélectrique induisent un retard à l'oxydation des couches semi-conductrices 102 et 104, différent et par exemple inférieur à celui induit par les blocs de masquage 412a, 412b, à base du deuxième matériau diélectrique. Lors de l'étape d'oxydation, la condensation du Germanium et la consommation du Silicium sont plus rapides dans des zones de la couche semi-conductrice 104 situées en regard des blocs de masquage 410a, 410b à base du premier matériau diélectrique 411 que dans d'autres zones de la couche semi-conductrice 104 situées en regard des blocs de masquage 412a, 412b à base du deuxième matériau diélectrique 413.

Suite à l'oxydation, on obtient sous les blocs de masquage 410a, 410b, à base du premier matériau diélectrique 411, des zones semi-conductrices 431a, 431b à base de Si_{1-y}Ge_{y}, ayant une première composition en Germanium, et une teneur en germanium telle que y=y₁ (avec y₁>x), y₁ étant par exemple de l'ordre de 0,8 à 1. Sous les blocs de masquage 412a, 412b à base du deuxième matériau, d'autres zones semi-conductrices 433a, 433b, à base de Si_{1-y}Ge_{y}, ayant une deuxième composition en Germanium différente de ladite première composition. Les zones semi-conductrices 433a, 433b situées sous les blocs de masquage à base du deuxième matériau diélectrique, peuvent avoir une teneur en Germanium inférieure à celle des zones semi-conductrices 431a, 431b situées sous les blocs de masquage à base du premier matériau diélectrique et telle que y=y₂ (avec x<y₂<y₁), y₂ étant par exemple de l'ordre de 0,1 à 0,3 (figure 4B).

Selon une mise en oeuvre particulière, dans un cas où le masquage 408 comporte en outre au moins une ouverture 415 dévoilant la couche semi-conductrice 104 et par exemple ayant un motif de grille de transistor, suite à l'oxydation, on obtient en regard de l'ouverture 415 une zone semi-conductrice 434 à base de Si_{1-y}Ge_{y}, ayant une troisième composition en Germanium, et une teneur en germanium telle que y=y₃ (avec X<Y₂<Y₃<Y₁).

Selon une variante, le masquage à oxydation peut être formé de matériaux différents, par exemple de blocs 410a, 410b à base d'un premier matériau diélectrique et de blocs 412a, 412b à base d'un deuxième matériau, métallique par exemple tel que du TiN.

Une autre variante de l'exemple de procédé décrit précédemment en liaison avec les figures 2A-2D, va à présent être donnée. Pour cette variante, on forme sur la fine couche semi-conductrice 102, la couche de masquage 203 et l'ensemble de trous 210, 212, 214, 216, dans cette couche de masquage 203. Puis un ensemble de zones semi-conductrices 504a, 504b, 504c, 504d, à base de Si₁₋ₓGeₓ (avec 0 < x ≤ 1, par exemple avec x de l'ordre de 0,1) ayant une teneur en Germanium identique est réalisée, par exemple par épitaxie au fond des trous 210, 212, 214, 216, sur la fine couche semi-conductrice 102 à base de Si (figure 5A).

On réalise ensuite (figure 5B) un premier ensemble de blocs 508a, 508b, 508c, de masquage comblant respectivement un trou et recouvrant une zone semi-conductrice à base de Si₁₋ₓGeₓ. Les blocs 508a, 508b, 508c, de masquage peuvent être à base d'un matériau diélectrique par exemple tel que du Si₃N₄. Parmi les zones semi-conductrices 504a, 504b, 504c, 504d, à base de Si₁₋ₓGeₓ, au moins une zone semi-conductrice 504c peut être mise à nue ou dévoilée et ne pas être recouverte par un bloc de masquage.

Une première étape d'oxydation des zones semi-conductrices 504a, 504b, 504c, 504d, est réalisée à haute température, à travers un premier masquage formé par la couche 203 ajourée et le premier ensemble de blocs de masquage 508a, 508b, 508c. En fonction de leurs épaisseurs respectives, les blocs de masquage 508a, 508b, 508c, induisent un retard plus ou moins important à l'oxydation de la couche semi-conductrice 102 et des zones semi-conductrices 504a, 504b, 504c, 504d. Une fois la première étape d'oxydation terminée, une première zone semi-conductrice 504a située sous un premier bloc de masquage 508a, une deuxième zone semi-conductrice 504b située sous un deuxième bloc de masquage 508b, et une troisième zone semi-conductrice 504c située sous un troisième bloc de masquage 508c, ont une teneur en Germanium différente de celle d'une quatrième zone semi-conductrice 504d située dans un trou 214 qui ne comporte pas de bloc de masquage, et qui est dévoilée ou à nu.

On réalise ensuite un deuxième masquage. Le deuxième masquage peut être formé d'un deuxième ensemble de blocs 518a, 518b, de masquage comblant respectivement un trou et recouvrant respectivement une zone semi-conductrice à base de Si₁₋ₓGeₓ. Le nombre de blocs de masquage 518a, 518b, du deuxième masquage, est différent de celui du premier masquage. Le nombre de blocs de masquage du deuxième ensemble de blocs 518a, 518b peut être inférieur à celui du premier masquage. Le deuxième masquage peut être tel qu'au moins une zone semi-conductrice 504c qui était située sous un bloc de masquage 508c du premier masquage est à présent dévoilée. Le deuxième masquage peut être également tel qu'au moins une zone semi-conductrice 504d qui était dévoilée lors de la première oxydation, reste dévoilée suite à la formation du deuxième masquage. Le deuxième masquage peut être réalisé par suppression de tous les blocs puis formation de nouveaux blocs ou par suppression d'un ou plusieurs blocs du premier masquage.

Une deuxième étape d'oxydation des zones 504a, 504b, 504c, 504d, est réalisée à haute température, à travers le deuxième masquage formé par la couche 203 ajourée et les blocs de masquage 518a, 518b.

Une fois la deuxième étape d'oxydation terminée, les zones semi-conductrices 504a, 504b, situées respectivement sous le premier bloc de masquage 508a, sous le deuxième bloc de masquage 508b, ont une une teneur en Germanium inférieure à celle des zones semi-conductrices 504c, 504d dévoilées lors de la deuxième oxydation. La teneur en Germanium de la zone semi-conductrice 504d qui a été dévoilée lors de la première oxydation et de la deuxième oxydation, est plus élevée que celle de la zone semi-conductrice 504c qui a été masquée lors de la première oxydation et dévoilée lors de la deuxième oxydation.

Un exemple de procédé, suivant l'invention, de réalisation d'un dispositif microélectronique doté de plusieurs zones semi-conductrices à base de Si_{1-y}Ge_{y} (avec 0 < y ≤ 1) ayant des compositions respectives en Germanium différentes formées sur un même substrat, va à présent être donné en liaison avec les figures 6A à 6E. Le matériau de départ du procédé peut être un substrat de type semi-conducteur sur isolant, par exemple de type SOI (SOI pour « silicon on insulator » ou silicium sur isolant) comprenant une couche de support 100 par exemple à base de Si, recouverte d'une couche de matériau diélectrique 101 par exemple une couche d'oxyde enterré (« burried oxyde » selon la terminologie anglo-saxonne) elle-même recouverte d'une couche semi-conductrice 602 par exemple à base de Si, et d'épaisseur comprise par exemple entre 5 et 100 nanomètres ou par exemple de l'ordre de 20 nanomètres.

On réalise tout d'abord des zones à base de Si d'épaisseurs différentes sur le substrat 100.

Pour cela, on peut former sur la couche semi-conductrice 602, une couche 608 qui peut être à base d'un matériau diélectrique, par exemple tel que du SiO₂, et d'épaisseur par exemple comprise entre 20 nanomètres et 1000 nanomètres. Puis, on effectue un retrait d'une partie de la couche 608 de masquage, de manière à donner à cette couche 608 une forme de biseau (figure 6A). Suite à ce retrait, la face supérieure de la couche 608 de masquage réalise un angle non nul avec le plan principal du support 100 ou forme une pente inclinée par rapport au plan principal du support 100 (le plan principal du support 100 étant défini comme un plan passant par le support 100 et parallèle au plan [O;*i̅*;*j̅*] d'un repère orthogonal [O;*i̅*.*j̅*;*k̅*]). Dans un cas, par exemple, où le matériau diélectrique de la couche 608 est du SiO₂, le retrait peut être effectué par exemple par trempage du substrat recouvert par la couche 608 de masquage, dans une solution à base de HF + H₂O, puis par retrait progressif de la solution.

Ensuite, on réalise une oxydation de la couche semi-conductrice 602, de manière à donner une forme de biseau à la fine couche semi-conductrice 102 (figure 6B). La couche 602 en biseau comporte ainsi une pluralité de zones 602a, 602b, 602c à base de Si d'épaisseur différentes reposant sur le substrat 100.

La couche 608 de masquage est ensuite retirée (figure 6C).

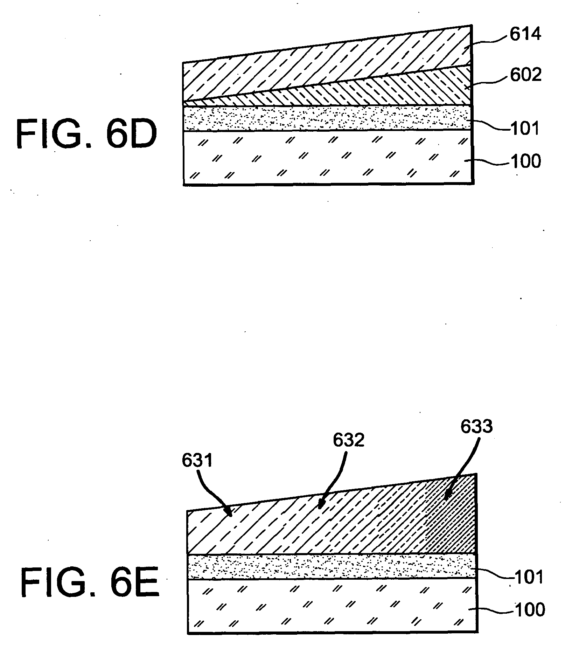

Sur la fine couche semi-conductrice 102 une autre couche semi-conductrice 614 à base de Si₁₋ₓGeₓ, avec 0<x<y<1, par exemple avec x de l'ordre de 0,1, d'épaisseur comprise par exemple entre 50 et 100 nanomètres ou par exemple entre 40 et 75 nanomètres est formée par exemple par épitaxie (figure 6D). Ensuite, on effectue une étape de condensation localisée du Ge de la couche 614 semi-conductrice à base de Si₁₋ₓGeₓ, par exemple à l'aide d'un procédé d'oxydation thermique tel que décrit précédemment. Suite à l'oxydation ou aux oxydations, des zones semi-conductrices 631, 632, 633 à base de Si_{1-y}Ge_{y} (avec y>x) et à différentes teneurs en Ge ou à différentes compositions en germanium sont formées. Un gradient de concentration en Ge peut être obtenu, dans une direction parallèle au plan principal du support 100. Les zones semi-conductrices 631, 632, 633 peuvent être recouvertes d'une fine couche isolante à base de SiO₂ formée lors de l'oxydation. Cette couche isolante peut être ensuite retirée (figure 6E).

Selon une variante (non représentée) de l'exemple qui vient d'être décrit, on peut réaliser des zones à base de Si d'épaisseurs différentes, par formation d'un masquage comportant une pluralité d'ouvertures dévoilant la couche 102 de silicium, puis formation, par exemple par plusieurs épitaxies, de blocs de silicium d'épaisseurs différentes au fond des ouvertures. On forme ensuite sur les blocs de silicium des blocs à base de Si₁₋ₓGeₓ, avec 0<x<y≤1, par exemple avec x de l'ordre de 0,1. Puis, réalise une oxydation thermique telle que décrite plus haut, des blocs à base de Si₁₋ₓGeₓ Suite à l'oxydation ou aux oxydations, des zones semi-conductrices 631, 632, 633 à base de Si_{1-y}Ge_{y} (avec y>x) et à différentes teneurs en Ge ou à différentes compositions en germanium sont formées.

## Revendications

1. Procédé de réalisation d'un dispositif microélectronique comportant une pluralité de zones semi-conductrices à base de Si_{1-y}Ge_{y} avec 0 < y ≤ 1 ayant des teneurs respectives en Germanium différentes, comprenant les étapes de :
a) formation sur une pluralité de zones semi-conductrices (602a, 602b, 602c) à base de Si et d'épaisseurs différentes reposant sur un support (100-101), d'une couche semi-conductrice (614) à base de Si₁₋ₓGeₓ avec 0 < x < 1 et x < y,
b) oxydation de la couche semi-conductrice (614) à base de Si₁₋ₓGeₓ.

2. Procédé selon la revendication 1, dans lequel les zones semi-conductrices (602a, 602b, 602c) et d'épaisseurs différentes sont des zones d'une couche (602) à base de Si en forme de biseau.

3. Procédé selon la revendication 2, la forme de biseau de la couche (602) à base de Si ayant été formée préalablement à l'étape a) par :
- formation d'un masquage (608) en forme de biseau sur la couche (602) à base de Si,
- oxydation de la couche de Si à travers ledit masquage (608) en forme de biseau,
- retrait dudit masquage (608) en forme de biseau.

4. Procédé selon la revendication 3, le masquage (608) en forme de biseau étant à base d'au moins un matériau isolant tel que du SiO₂.

## Claims

1. Method for producing a microelectronic device including a plurality of Si_{1-y}Ge_{y} based semi-conductor zones (where 0 < y ≤ 1) which has different respective Germanium contents, comprising the steps of:
a) the formation on a plurality of Si based semi-conductor zones and of different thicknesses rest on a substrate, of a Si₁₋ₓGeₓ based semi-conductor layer (614) (where 0 < x < 1 and x < y),
b) the oxidation of the Si₁₋ₓGeₓ based semi-conductor layer.

2. Method of claim 1, in which the semi-conductor zones of different thicknesses are zones of a Si based layer in the form of a bevel.

3. Method according to any of claim 1 or 2, wherein the bevel form of the Si based layer has been formed prior to step a) by:
- the formation of a mask in the form of a bevel on the Si based layer,
- oxidation of the Si layer through said mask in the form of a bevel,
- removal of the said mask in the form of a bevel.

4. Method according to any of claims 1 to 3, wherein the mask in the form of a bevel is based at least an insulating material such as SiO₂.

## Patentansprüche

1. Verfahren zur Herstellung einer mikroelektronischen Vorrichtung mit mehreren von halbleitenden Zonen auf der Basis von Si_{1-y}Ge_{y} mit 0 < y ≤ 1 und jeweils unterschiedlichen Germaniumgehalten,
die folgenden Schritte umfassend:
a) Ausbildung einer auf einem Träger (100-101) ruhenden halbleitenden Schicht (614) auf der Basis von Si₁₋ₓGeₓ mit 0 < x < 1 und x < y auf mehreren auf Si basierender halbleitender Zonen (602a, 602b, 602c) mit unterschiedlichen Dicken,
b) Oxidation der auf Si₁₋ₓGeₓ-basierenden halbleitenden Schicht (614).

2. Verfahren nach Anspruch 1, bei dem die halbleitenden und unterschiedlich dicken Zonen (602a, 602b, 602c) Zonen einer keilförmigen Schicht (602) sind.

3. Verfahren nach Anspruch 2, wobei die Keilform der auf Si basierenden Schicht (602) vor dem Schritt a) realisiert wird durch:
- Ausbildung einer keilförmigen Maskierung (608) auf der auf Si basierenden Schicht (602),
- Oxidation der Si-Schicht durch die genannte keilförmige Maskierung (608) hindurch,
- Entfernung der genannten keilförmigen Maskierung (608).

4. Verfahren nach Anspruch 3, wobei die Abschrägung förmige Maskierung (608) auf wenigstens einem isolierenden Material wie etwa SiO₂ basiert.
